# EUROPÄISCHE PATENTSCHRIFT

(11) **EP 2 576 858 B1**
(45) Veröffentlichungstag und Bekanntmachung des Hinweises auf die Patenterteilung: **30.03.2016**
(21) Anmeldenummer: 11720804.1
(22) Anmeldetag: 24.05.2011
(51) Int. Cl.: C23C 16/26, F02F 3/00, F02F 5/00, F02F 1/00, F16J 9/26

(54) **Kolbenring oder Zylinderlaufbuchse.**
Piston ring or cylinder liner.
Segment de piston ou chemise de cylindre.

(30) Priorität: 25.05.2010 DE 102010029256
(43) Veröffentlichungstag der Anmeldung: 10.04.2013
(73) Patentinhaber: Federal-Mogul Burscheid GmbH, 51399 Burscheid (DE)
(72) Erfinder: HOPPE, Steffen, Dr., 51491 Overath (DE); KENNEDY, Marcus, Dr., 40477 Düsseldorf (DE); FISCHER, Manfred, Dr., 42799 Leichlingen (DE); ZINNABOLD, Michael, 51399 Burscheid (DE); AHARONOV, Robert R., W. Bloomfield Michigan 48322 (US)
(74) Vertreter: Hoffmann Eitle
(86) Internationale Anmeldenummer: PCT/EP2011/058427
(87) Internationale Veröffentlichungsnummer: WO 2011/147808

(56) Entgegenhaltungen:
- US-A- 5 275 850

## Beschreibung

### Technisches Gebiet

Die Anmeldung betrifft ein Gleitelement, insbesondere einen Kolbenring oder eine Zylinderlaufbuchse, umfassend zumindest eine a-C:H:Me-Schicht, wobei Me für Germanium und Silizium steht.

### Stand der Technik

Das Ziel der Reduktion der CO₂-Emissionen bei Verbrennungsmotoren kann im Wesentlichen nur durch eine Verminderung des Kraftstoffverbrauchs erreicht werden. Dabei spielen die Reibungsverluste im Motor sowie der Verschleiß eine wesentliche Rolle. Die Kolbengruppe und damit die Kolbenringe sind für einen großen Anteil der Reibungsverluste verantwortlich.

Bei hoch belasteten Motoren besteht daneben die Anforderung Kolbenringe mit Laufflächenbeschichtungen zu versehen, die eine hohe Verschleißbeständigkeit aufweisen. Zunehmend kommen dafür Beschichtungen auf Hartstoffbasis zum Einsatz, die mittels PVD (physikalischer Dampfabscheidung) oder CVD (chemische Dampfabscheidung) aufgebracht werden. Diese sollen die Funktionsfähigkeit über die Lebensdauer gewährleisten.

Es ist bekannt, dass DLC (diamond like carbon)-Schichten zumeist sehr geringe Reibungskoeffizienten gegenüber dem Laufpartner aufweisen, da sie eine sehr geringe Tendenz zur Adhäsion zeigen. Dadurch können die Reibungsverluste im Motor effektiv verringert werden.

Z.B. beschreibt DE 10 2005 063 123 ein Gleitelement umfassend mindestens eine Oberfläche für einen gleitenden Kontakt mit einer Lauffläche, auf die eine Verschleißschicht und eine Einlaufschicht aus Kohlenstoff aufgebracht sind, wobei die Einlaufschicht Wasserstoff und nanokristalline Karbidphasen enthält. Diese Beschichtung führt zu einem sehr guten Einlaufverhalten.

US 6,279,913 beschreibt ein Gleitelement mit einer DLC-Schicht auf der Gleitoberfläche. Die DLC-Schicht besitzt dabei eine kugelförmige Oberflächenstruktur mit einer Schichtdicke von 0,5-30 µm. Die DLC-Schicht hat entweder eine amorphe, eine amorphe/diamantähnliche oder eine amorphe/graphitähnliche Kohlenstoff-Struktur.

US 6,325,385 beschreibt ebenfalls einen Kolbenring, der eine DLC-Schicht aufweist. Diese ist auf eine Unterschicht aufgebracht. Die Unterschicht besteht aus einem oder mehreren Elementen ausgewählt aus der Gruppe bestehend aus Silizium, Titan, Wolfram, Chrom, Molybdän, Niob und Vanadium in einer Menge von 70 Atom-% oder mehr und unter 100 Atom-%, wobei der Rest aus Kohlenstoff besteht, oder aus einem oder mehreren dieser Elemente in einer Menge von 100 Atom-%. Die Unterschicht macht einen Anteil von 1-35 % der Gesamtdicke der DLC- und der Unterschicht aus, so dass ihre Dicke im Bereich von 0,05-1,75 µm liegt.

Gemäß US 6,325,385 dient die dünne Unterschicht der Verringerung von Spannungen, die im Inneren der DLC-Schicht auftreten. Dadurch wird die Adhäsion der DLC-Schicht erhöht und das Auftreten von Defekten, wie Rissen oder Vertiefungen, in der Schicht vermieden. Die Unterschicht hat jedoch ausweislich US 6,325,385 eine schlechte Verschleißbeständigkeit, und soll daher, nachdem sie durch Verschleiß der DLC-Schicht freigelegt wurde, schnell abgetragen werden.

Die Lebensdauer solcher DLC-Schichten ist jedoch u.a. aufgrund der geringen Schichtdicken begrenzt, so dass die Reibung nur für einen gewissen Zeitraum reduziert werden kann. So entfaltet auch die DLC-Schicht des Kolbenrings der US 6,325,385 ihre Wirkung aufgrund ihrer geringen Dicke hauptsächlich in der Einlaufphase. Danach steigen die Reibungsverluste aufgrund des dann veränderten tribologischen Systems wieder an.

Es besteht daher ein Bedürfnis nach einem Gleitelement, insbesondere einem Kolbenring oder einer Zylinderlaufbuchse, mit dem sich ein niedriger Reibungskoeffizient für einen längeren Zeitraum, vorzugsweise für die gesamte Lebensdauer des Verbrennungsmotors, in dem das Gleitelement eingesetzt wird, gewährleisten lässt.

### Zusammenfassung der Erfindung

Die Erfindung betrifft einen Kolbenring oder eine Zylinderlaufbuchse, umfassend zumindest in einem Teilbereich mindestens eine a-C:H:Me-Schicht, wobei die Schicht(en) als Me sowohl Germanium als auch Silizium enthält/enthalten, und die Dicke der a-C:H:Me- Schicht (en) 15-40 um beträgt.

### Beschreibung der Figuren

- Fig. 1: zeigt REM und EDX-Diagramme des Kobenrings aus Beispiel 1
- Fig. 2: zeigt REM und EDX-Diagramme des Kobenrings aus Beispiel 2

### Detaillierte Beschreibung der Erfindung

Bei der im Rahmen der vorliegenden Erfindung eingesetzten a-C:H:Me-Schicht handelt es sich um eine amorphe DLC-Schicht aus Kohlenstoff und Wasserstoff, die ferner sowohl Germanium als auch Silizium enthält.

Es wird angenommen, dass Germanium und Silizium die Eigenspannung in der Schicht reduzieren (siehe auch US 6,086,769) und so die Abscheidung von Schichten mit größerer Dicke als im Stand der Technik ermöglichen.

Im Rahmen der vorliegenden Erfindung können eine oder mehrere a-C:H:Me-Schichten auf das Gleitelement aufgebracht werden. Wenn mehrere Schichten eingesetzt werden, so unterscheiden sich diese z.B. in der Zusammensetzung. Die Gesamtdicke der a-C:H:Me-Schicht(en) beträgt 15-40 µm, bevorzugt 15-30 µm.

Der Gehalt an Germanium und Silizium in der Schicht beträgt bevorzugt 5-70 Gew.-%, besonders bevorzugt 40-60 Gew.-%. Wenn der Gehalt an Germanium und Silizium in diesem Bereich liegt, dann werden die Eigenspannungen reduziert, so dass sehr große Schichtdicken erhalten werden können.

In einer besonders bevorzugten Ausführungsform liegt der Gehalt von Germanium und Silizium in der Schicht bevorzugt jeweils bei 5-35 Gew.-%, insbesondere 20-30 Gew.-%.

Das Verhältnis von Germanium und Silizium in der erfindungsgemäßen Schicht beträgt bevorzugt 1:7 bis 7:1, bevorzugt 1:2 bis 2:1.

Bevorzugt enthält das erfindungsgemäße Gleitelement ferner eine a-C:H-Schicht, d.h. eine amorphe DLC-Schicht umfassend Kohlenstoff und Wasserstoff, die frei von Germanium und Silizium ist. Diese a-C:H-Schicht wird bevorzugt als Deckschicht auf die a-C:H:Me-Schicht aufgebracht. Diese a-C:H-Schicht führt durch ihren höheren Verschleißwiderstand aufgrund des metallfreien Zustands zu einem optimalen Einlaufverhalten. Zweckmäßig hat die a-C:H-Schicht eine Dicke von bis zu 3 µm, da es bei Schichtdicken von mehr als 3µm aufgrund der dann zu hohen Eigenspannungen innerhalb der metallfreien Schicht zu Problemen mit der Haftung kommen kann.

In dem erfindungsgemäßen Gleitelement sind die obigen Schichten vorzugsweise auf einen Grundkörper aus Gusseisen oder Stahlmaterial aufgebracht.

Die einzelnen Schichten können auf den Grundkörper z.B. mittels plasmaverstärkter chemischer Dampfabscheidung (plasma enhanced chemical vapor deposition) oder Glimmentladung aufgebracht werden. Geeignete Verfahren sind z.B. in WO 2009/006179 und WO 2009/011801 beschrieben, deren Offenbarung durch die Bezugnahme eingeschlossen sein soll.

Das erfindungsgemäße Gleitelement ist für eine Vielzahl von Anwendungen geeignet und wird bevorzugt für Kolbenringe oder Zylinderlaufbuchsen eingesetzt.

Die Erfindung wird unten durch Beispiele näher erläutert. Diese Beispiele sollen jedoch den Umfang der Erfindung in keiner Weise beschränken.

### Beispiele 1 und 2

| | Schichtdicke [µm] | Gew.-% | | |
|---|---|---|---|---|
| | | C + H | Si | Ge |
| Bsp. 1 (Vgl.) | 4-5 | 62, 4 | 37, 6 | 0 |
| | 6-7 | 49, 4 | 26 | 24, 6 |
| | 1 | 100 | | |
| Bsp. 2 | 21 | 49, 6 | 25, 9 | 24, 5 |
| | 1 | 100 | | |

An den o.g. Proben wurden die Härte und das Eindringmodul an der Lauffläche des Kolbenrings mittels eines Picodentors HM500 entsprechend DIN EN ISO 14577-1 gemessen.

Die folgenden Ergebnisse wurden erhalten:

| | Härte HV0, 02 | Eindringmodul [GPa] |
|---|---|---|
| Beispiel 1 (Vergleich) | 1672 ± 41 | 116 ± 2 |
| Beispiel 2 | 1602 ± 44 | 112 ± 2 |

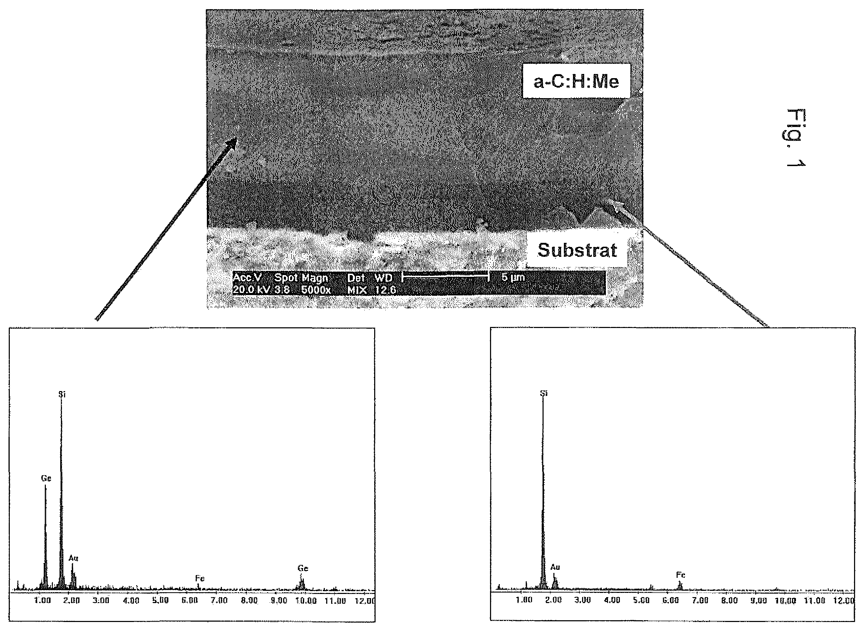

Fig. 1 zeigt den Schichtaufbau mittels REM und EDX-Diagrammen des in Beispiel 1 erhaltenden Kolbenrings.

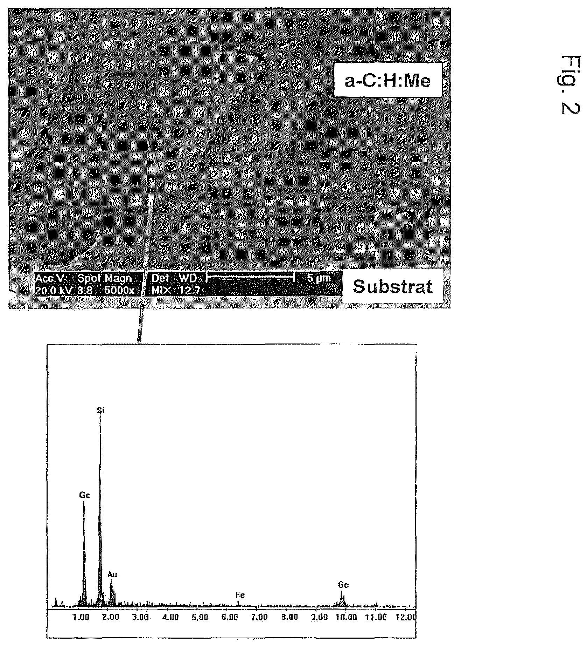

Fig. 2 zeigt den Schichtaufbau mittels REM und EDX-Diagrammen des in Beispiel 2 erhaltenden Kolbenrings.

## Patentansprüche

1. Kolbenring oder Zylinderlaufbuchse, umfassend ein Gleitelement, umfassend zumindest in einem Teilbereich mindestens eine a-C:H:Me-Schicht, wobei die Schicht als Me sowohl Germanium als auch Silizium enthält, und die Dicke der a-C:H:Me-Schicht(en) 15-40 µm beträgt.

2. Kolbenring oder Zylinderlaufbuchse, umfassend ein Gleitelement nach Anspruch 1 **dadurch gekennzeichnet, dass** der Me-Gehalt in der Schicht 5-70 Gew.-%, bevorzugt 40-60 Gew.-%, beträgt.

3. Kolbenring oder Zylinderlaufbuchse, umfassend ein Gleitelement nach Anspruch 1 oder 2, wobei das Verhältnis von Germanium und Silizium in der Schicht von 1:7 bis 7:1, bevorzugt 1:2 bis 2:1, beträgt.

4. Kolbenring oder Zylinderlaufbuchse, umfassend ein Gleitelement nach einem der Ansprüche 1-3, wobei der Gehalt von Germanium und Silizium in der Schicht jeweils 5-35 Gew.-%, bevorzugt 20-30 Gew.-%, beträgt.

5. Kolbenring oder Zylinderlaufbuchse, umfassend ein Gleitelement nach einem der vorangehenden Ansprüche, wobei die Dicke der a-C:H:Me-Schicht(en) 15-30 µm beträgt.

6. Kolbenring oder Zylinderlaufbuchse, umfassend ein Gleitelement nach einem der vorangehenden Ansprüche, umfassend ferner eine a-C:H-Schicht.

7. Kolbenring oder Zylinderlaufbuchse, umfassend ein Gleitelement nach Anspruch 6, wobei die a-C:H-Schicht die Deckschicht ist.

8. Kolbenring oder Zylinderlaufbuchse, umfassend ein Gleitelement nach Anspruch 6 oder 7, wobei die Dicke der a-C:H-Schicht nicht mehr als 3 µm beträgt.

9. Kolbenring oder Zylinderlaufbuchse, umfassend ein Gleitelement nach Anspruch 7 oder 8, wobei die Härte, gemessen mittels eines Picodentors HM500 entsprechend DIN EN ISO 14577-1, auf der Lauffläche 1400 - 1900 HV0,02, bevorzugt 1500 - 1800 HV0,02, beträgt.

10. Kolbenring oder Zylinderlaufbuchse, umfassend ein Gleitelement nach Anspruch 9, wobei der Eindringmodul, gemessen mittels eines Picodentors HM500 entsprechend DIN EN ISO 14577-1, auf der Lauffläche 100 - 130 GPa, bevorzugt 105 - 125 GPa, beträgt.

11. Kolbenring oder Zylinderlaufbuchse, umfassend ein Gleitelement nach einem der vorangehenden Ansprüche, umfassend einen Grundkörper aus Gusseisen oder Stahlmaterial.

12. Kolbenring oder Zylinderlaufbuchse, umfassend ein Gleitelement nach einem der vorangehenden Ansprüche, wobei die Schicht zumindest in dem Bereich aufgebracht ist, der für den gleitenden Kontakt mit dem Laufpartner vorgesehen ist.

## Claims

1. Piston ring or cylinder liner comprising a sliding element comprising at least in one section, at least one a-C:H:Me layer, wherein the layer as Me contains both germanium and silicon, and the thickness of the a-C:H:Me layer(s) is 15-40 µm.

2. Piston ring or cylinder liner comprising a sliding element according to claim 1, **characterised in that** the Me content in the layer is 5-70 wt.%, preferably 40-60 wt.%.

3. Piston ring or cylinder liner comprising a sliding element according to claim 1 or 2, wherein the ratio of germanium and silicon in the layer is from 1:7 to 7:1, preferably 1:2 to 2:1.

4. Piston ring or cylinder liner comprising a sliding element according to one of claims 1-3, wherein the ratio of germanium and silicon in the layer is in each case 5-35 wt.%, preferably 20-30 wt.%.

5. Piston ring or cylinder liner comprising a sliding element according to one of the preceding claims, wherein the thickness of the a-C:H:Me layer(s) is 15-30 µm.

6. Piston ring or cylinder liner comprising a sliding element according to one of the preceding claims, further comprising an a-C:H layer.

7. Piston ring or cylinder liner comprising a sliding element according to claim 6, wherein the a-C:H layer is the cover layer.

8. Piston ring or cylinder liner comprising a sliding element according to claim 6 or 7, wherein the thickness of the a-C:H layer is no more than 3 µm.

9. Piston ring or cylinder liner comprising a sliding element according to claim 7 or 8, wherein the hardness on the running surface, measured by means of a Picodentor HM500 according to DIN EN ISO 14577-1, is 1,400 - 1,900 HV 0.02, preferably 1,500 - 1,800 HV 0.02.

10. Piston ring or cylinder liner comprising a sliding element according to claim 9, wherein the indentation modulus on the running surface, measured by means of a Picodentor HM500 according to DIN EN ISO 14577-1, is 100 - 130 GPa, preferably 105 -125 GPa.

11. Piston ring or cylinder liner comprising a sliding element according to one of the preceding claims, comprising a base body made from cast iron or steel material.

12. Piston ring or cylinder liner comprising a sliding element according to one of the preceding claims, wherein the layer is applied at least in the region which is intended for sliding contact with the running partner.

## Revendications

1. Segment de piston ou chemise de cylindre, comprenant un élément coulissant, comprenant au moins dans une zone partielle au moins une couche de a-C:H:Me, dans lequel ou laquelle la couche contient en tant que Me aussi bien du germanium que du silicium et l'épaisseur de la couche ou des couches de a-C:H:Me est r de 15 à 40 µm.

2. Segment de piston ou chemise de cylindre, comprenant un élément coulissant selon la revendication 1, caractérisé(e) en ce que la teneur en Me dans la couche est de 5 à 70 % en poids, de manière préférée de 40 à 60 % en poids.

3. Segment de piston ou chemise de cylindre, comprenant un élément coulissant selon la revendication 1 ou 2, dans lequel ou laquelle le rapport entre le germanium et le silicium dans la couche est de 1:7 à 7:1, de manière préférée de 1:2 à 2:1.

4. Segment de piston ou chemise de cylindre, comprenant un élément coulissant selon l'une quelconque des revendications 1 à 3, dans lequel ou laquelle la teneur en germanium et en silicium dans la couche est respectivement de 5 à 35 % en poids, de manière préférée de 20 à 30 % en poids.

5. Segment de piston ou chemise de cylindre, comprenant un élément coulissant selon l'une quelconque des revendications précédentes, dans lequel ou laquelle l'épaisseur de la couche ou des couches de a-C:H:Me est de 15 à 30 µm.

6. Segment de piston ou chemise de cylindre, comprenant un élément coulissant selon l'une quelconque des revendications précédentes, comprenant en outre une couche de a-C:H.

7. Segment de piston ou chemise de cylindre, comprenant un élément coulissant selon la revendication 6, dans lequel ou laquelle la couche de a-C:H est la couche de recouvrement.

8. Segment de piston ou chemise de cylindre, comprenant un élément coulissant selon la revendication 6 ou 7, dans lequel ou laquelle l'épaisseur de la couche de a-C:H ne présentant pas de valeur supérieure à 3 µm.

9. Segment de piston ou chemise de cylindre, comprenant un élément coulissant selon la revendication 7 ou 8, dans lequel ou laquelle la dureté, mesurée au moyen d'un système Picodentor HM500 selon la norme DIN EN ISO 14577-1, présente, sur la surface de roulement, une valeur de 1400 à 1900 HV0,02, de manière préférée de 1500 à 1800 HV0,02.

10. Segment de piston ou chemise de cylindre, comprenant un élément coulissant selon la revendication 9, dans lequel ou laquelle le module d'indentation, mesuré au moyen d'un système Picodentor HM500 selon la norme DIN EN ISO 14577-1, présente, sur la surface de roulement, une valeur de 100 à 130 GPa, de manière préférée de 105 à 125 GPa.

11. Segment de piston ou chemise de cylindre, comprenant un élément coulissant selon l'une quelconque des revendications précédentes, comprenant un corps de base en fonte ou en matériau à base d'acier.

12. Segment de piston ou chemise de cylindre, comprenant un élément coulissant selon l'une quelconque des revendications précédentes, dans lequel ou laquelle la couche est appliquée au moins dans la zone qui est prévue pour le contact par coulissement avec le partenaire de roulement.
